# EUROPEAN PATENT APPLICATION

(11) **EP 4 657 809 A1**
(43) Date of publication of application: **03.12.2025**
(21) Application number: 23926318.9
(22) Date of filing: 09.03.2023
(51) Int. Cl.: H04L 27/36

(54) **PROBABILISTIC SHAPING CODING CIRCUIT AND PROBABILISTIC SHAPING CODING METHOD**

(71) Applicant: Mitsubishi Electric Corporation, Tokyo 100-8310 (JP)
(72) Inventor: YOSHIDA, Tsuyoshi, Tokyo 100-8310 (JP)
(74) Representative: Plasseraud IP
(86) International application number: PCT/JP2023/008946
(87) International publication number: WO 2024/185108

(57) **Abstract**

A probabilistic shaping encoding circuit (1) includes: with x, m, and n[x] being natural numbers (m = 1, 2,..., n[x]), an m-th lookup table (11) of a layer x + 1 to convert an m-th transmission bit string of the layer x + 1 including an m-th transmission information bit string of the layer x + 1 which is a part of an information bit sequence of a communication target and an m-th transmission address bit string of the layer x + 1 into an m-th transmission shaping bit string of the layer x + 1; an m-th distribution circuit (12) of the layer x to convert the m-th transmission shaping bit string of the layer x + 1 into a (2m-1)-th transmission source address bit string of the layer x and a 2m-th transmission source address bit string of the layer x; a (2m-1)-th lookup table (14) of the layer x to generate a (2m-1)-th transmission shaping bit string of the layer x from the (2m-1)-th transmission source address bit string of the layer x and a (2m-1)-th transmission information bit string of the layer x which is a part of the information bit sequence of the communication target; and a 2m-th lookup table (15) of the layer x to generate a 2m-th transmission shaping bit string of the layer x from the 2m-th transmission source address bit string of the layer x and a 2m-th transmission information bit string of the layer x which is a part of the information bit sequence of the communication target.

Each of the lookup tables is hierarchized in a tree shape, each of the transmission source address bit strings obtained by the m-th distribution circuit (12) of the layer x corresponds to designation information designating a combination of signal point groups in a signal space managed by each of a plurality of lookup tables of the layer x, each of the transmission shaping bit strings generated by the (2m-1)-th lookup table (14) of the layer x and the 2m-th lookup table (15) of the layer x corresponds to designation information designating a combination of signal point groups in a signal space managed by each of a plurality of lookup tables of a layer immediately below or signal point information indicating a signal point arrangement of the signal space.

## Description

### TECHNICAL FIELD

The present disclosure relates to a probabilistic shaping encoding circuit and a probabilistic shaping encoding method.

### BACKGROUND ART

In order to implement a high throughput in optical communication, for example, it is effective to increase a modulation level degree. When the modulation multilevel degree is increased, it is usual that quadrature amplitude modulation (hereinafter, referred to as QAM) is performed on a transmission side of signal communication and coherent detection and digital signal processing are performed on a reception side.

On the other hand, when the number of bits placed on the QAM signal is increased, the number of signal points is also increased, and the minimum distance between the signal points with respect to the average power of the signal is reduced. This increases the signal-to-noise ratio (hereinafter, referred to as SNR) required to obtain constant communication quality and limits the applicable transmission conditions.

In optical communication, there are many cases where an allowable value of an error rate is very small, and it is normal to perform error correction in a high-end device. Particularly, when performance is emphasized, soft decision error correction is used. A combination of multi-valued QAM and soft decision error correction has been studied so far, and a combination of probabilistic shaping is further studied.

Techniques for shaping an arrangement of signal points include geometric shaping for shaping the position of each of a plurality of signal points and probabilistic shaping for shaping the probability that each of the plurality of signal points can take. In any case, it is possible to asymptotically bring the relationship of the transmission capacity with respect to the SNR to a Shannon limit. This contributes, for example, to increasing the communication capacity of a client signal under a given transmission condition.

Among them, when a symbol to which probabilistic shaping for improving the performance by giving a bias to the occurrence probability of each signal point is applied is input to a communication path, encoding processing corresponding to the probabilistic shaping is required. For example, Patent Literature 1 discloses a probabilistic shaping encoding technique based on hierarchical distribution matching, and it is assumed that the encoding processing by the probabilistic shaping encoding technique is performed on the transmission side of signal communication.

In a circuit (hereinafter, also referred to as a "conventional circuit") using the probabilistic shaping encoding technology described in Patent Literature 1, a transmission information bit string is converted into a bit string (transmission shaping bit string) corresponding to a symbol string in which a probability distribution is shaped by a lookup table (LUT) arranged in a hierarchical manner. In a case where a single LUT is used, the circuit scale of the LUT exponentially increases as the number of input/output bits of the LUT increases, but dividing of the LUT is possible in the conventional circuit. Thus, in the conventional circuit, it is possible to reduce the circuit scale by suppressing the number of input/output bits of each LUT while increasing the number of input/output bits (block length) of the entire circuit to achieve high performance.

### CITATION LIST

### PATENT LITERATURES

Patent Literature 1: Japanese Patent No. 6820131

### SUMMARY OF INVENTION

### TECHNICAL PROBLEM

However, in the conventional circuit, when the number of input/output bits of each divided LUT is small, performance degradation occurs in probabilistic distribution shaping. For example, in the above-described conventional circuit, in a case where the number of input/output bits of each LUT is small, the relationship of the transmission capacitance with respect to the predetermined SNR deviates from the Shannon limit, or the SNR necessary for implementing the predetermined transmission capacitance increases. In order to prevent such performance deterioration, it is necessary to increase the number of input/output bits of each LUT, but there is a problem that the circuit scale increases when the number of input/output bits of each LUT is increased.

The present disclosure has been made to solve the above problems, and an object of the present disclosure is to obtain a probabilistic shaping encoding circuit in which the circuit scale is reduced while performance degradation is suppressed with respect to a conventional circuit.

### SOLUTION TO PROBLEM

A probabilistic shaping encoding circuit according to the present disclosure includes: with x, m, and n[x] being natural numbers (m = 1, 2,..., n[x]), an m-th lookup table of a layer x + 1 to convert an m-th transmission bit string of the layer x + 1 including an m-th transmission information bit string of the layer x + 1 which is a part of an information bit sequence of a communication target and an m-th transmission address bit string of the layer x + 1 into an m-th transmission shaping bit string of the layer x + 1; an m-th distribution circuit of the layer x to convert the m-th transmission shaping bit string of the layer x + 1 into a (2m-1)-th transmission source address bit string of the layer x and a 2m-th transmission source address bit string of the layer x; a (2m-1)-th lookup table of the layer x to generate a (2m-1)-th transmission shaping bit string of the layer x from the (2m-1)-th transmission source address bit string of the layer x and a (2m-1)-th transmission information bit string of the layer x which is a part of the information bit sequence of the communication target; and a 2m-th lookup table of the layer x to generate a 2m-th transmission shaping bit string of the layer x from the 2m-th transmission source address bit string of the layer x and a 2m-th transmission information bit string of the layer x which is a part of the information bit sequence of the communication target.

Each of the lookup tables is hierarchized in a tree shape, each of the transmission source address bit strings obtained by the m-th distribution circuit of the layer x corresponds to designation information designating a combination of signal point groups in a signal space managed by each of a plurality of lookup tables of the layer x, each of the transmission shaping bit strings generated by the (2m-1)-th lookup table of the layer x and the 2m-th lookup table of the layer x corresponds to designation information designating a combination of signal point groups in a signal space managed by each of a plurality of lookup tables of a layer immediately below or signal point information indicating a signal point arrangement of the signal space.

### ADVANTAGEOUS EFFECTS OF INVENTION

According to the present disclosure, it is possible to obtain a probabilistic shaping encoding circuit in which a circuit scale is reduced while performance degradation is suppressed as compared with a conventional circuit.

### BRIEF DESCRIPTION OF DRAWINGS

FIG. 1 is a block diagram illustrating a configuration of a probabilistic shaping encoding circuit according to a first embodiment.
FIG. 2 is a diagram extracting and illustrating a circuit configuration between a (x + 1)-th layer and an x-th layer immediately below the (x + 1)-th layer as a representative example in the probabilistic shaping encoding circuit illustrated in FIG. 1.
FIGS. 3A and 3B are diagrams illustrating an example of processing by a distribution circuit in the first embodiment.
FIG. 4 is a diagram illustrating an example of processing by a distribution circuit in the first embodiment.
FIG. 5 is a diagram illustrating an example of an algorithm describing processing by the address replacing circuit according to the first embodiment.
FIGs. 6A and 6B are diagrams for describing an effect of the probabilistic shaping encoding circuit according to the first embodiment, FIG. 6A is a diagram illustrating a configuration example of a conventional probabilistic shaping encoding circuit, and FIG. 6B is a diagram illustrating a configuration example of a probabilistic shaping encoding circuit according to the first embodiment.
FIG. 7 is a flowchart illustrating an operation example of the probabilistic shaping encoding circuit according to the first embodiment.
FIG. 8A is a block diagram illustrating a hardware configuration for implementing functions of the probabilistic shaping encoding circuit, and FIG. 8B is a block diagram illustrating a hardware configuration for executing software for implementing the functions of the probabilistic shaping encoding circuit.

### DESCRIPTION OF EMBODIMENTS

Hereinafter, embodiments of the present disclosure will be described in detail with reference to the drawings.

### First Embodiment

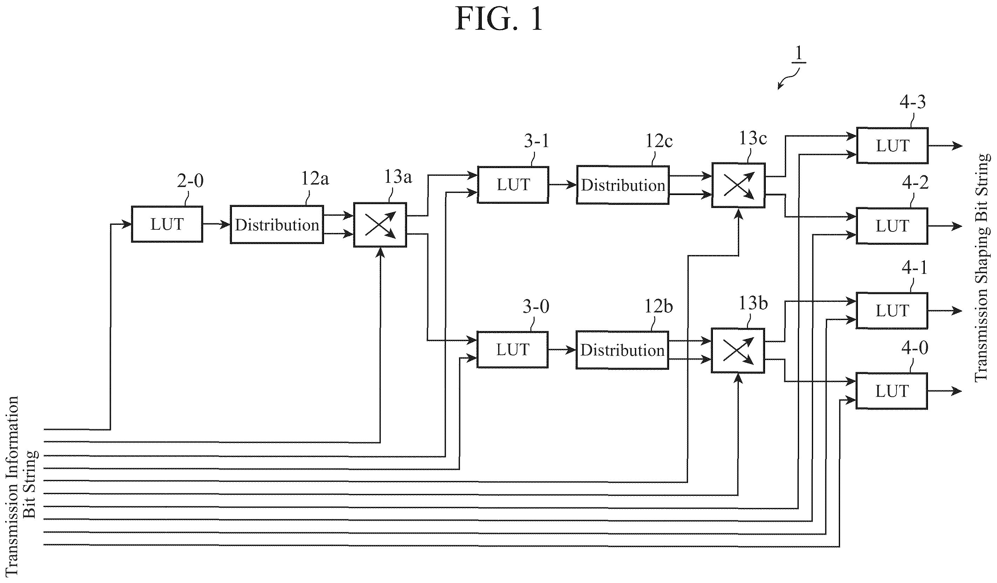

FIG. 1 is a block diagram illustrating a configuration of a probabilistic shaping encoding circuit 1 according to a first embodiment. The probabilistic shaping encoding circuit 1 is provided in, for example, an optical transmission device, and generates (encodes) a probabilistic distribution shaping signal in optical modulation of a transmission signal performed by the optical transmission device.

The probabilistic shaping encoding circuit 1 is configured on the premise of a circuit based on a lookup table (LUT) group arranged in a hierarchical manner in the conventional circuit described above, and has a configuration in which a distribution circuit and an address replacing circuit are additionally provided between the LUTs arranged in the hierarchical manner.

For example, as illustrated in FIG. 1, the probabilistic shaping encoding circuit 1 includes an LUT group hierarchized in a tree shape, that is, an LUT 2-0, an LUT 3-0, an LUT 3-1, an LUT 4-0, an LUT 4-1, an LUT 4-2, and an LUT 4-3, and a distribution circuit 12 (12a, 12b, and 12c) and an address replacing circuit 13 (13a, 13b, and 13c) provided between these LUTs. Data associated with an address is registered in each of these LUTs.

FIG. 1 illustrates a probabilistic shaping encoding circuit 1 having three-layer tree-like hierarchical LUTs. Here, the number of layers of the LUT may be two layers or less or four layers or more. The LUT 2-0 is an LUT of the second layer which is the uppermost layer. The LUT 3-0 and the LUT 3-1 are LUTs of the first layer which is an intermediate layer, and the LUT 3-0 and the LUT 3-1 of the layer immediately below are connected to the LUT 2-0 via the distribution circuit 12a and the address replacing circuit 13a.

The LUT 4-0, the LUT 4-1, the LUT 4-2, and the LUT 4-3 are LUTs of a 0-th layer which is the lowermost layer. The LUT 4-0 and the LUT 4-1 of the layer immediately below are connected to the LUT 3-0 via the distribution circuit 12b and the address replacing circuit 13b, and the LUT 4-2 and the LUT 4-3 of the layer immediately below are connected to the LUT 3-1 via the distribution circuit 12c and the address replacing circuit 13c.

Each of the LUT 2-0, the LUT 3-0, the LUT 3-1, the LUT 4-0, the LUT 4-1, the LUT 4-2, and the LUT 4-3 manages a signal space. For example, the signal space managed by the LUT 4-0 is a space (S0) of two QAM signals, the signal space managed by the LUT 4-1 is a space (S1) of another two QAM signals, the signal space managed by the LUT 4-2 is a space (S2) of still another two QAM signals, and the signal space managed by the LUT 4-3 is a space (S3) of yet another two QAM signals. At this time, the signal spaces managed by the LUT 3-0 are the signal spaces S0 and S1 managed by the LUT 4-0 and the LUT 4-1, and the signal spaces managed by the LUT 3-1 are the signal spaces S2 and S3 managed by the LUT 4-2 and the LUT 4-3. The signal spaces managed by the LUT 2-0 are signal spaces S0, S1, S2, and S3 managed by the LUT 3-0 and the LUT 3-1. The signal point is a point of a complex amplitude value in a signal space (constellation) diagram.

A part of a transmission information bit string as external input information is input to each of the LUT 2-0, the LUT 3-0, the LUT 3-1, the LUT 4-0, the LUT 4-1, the LUT 4-2, and the LUT 4-3. Further, some bits of the transmission information bit string are input as transmission address replacing bits to the address replacing circuit 13 (13a, 13b, and 13c). The transmission information bit string as external input information is an information bit sequence as a communication target, and is input from the outside to the probabilistic shaping encoding circuit 1 as a client signal or a framed signal. In one clock cycle, the total value of the number of bits of the transmission information bit string is a number represented by any positive integer. The clock cycle is, for example, 2 nanoseconds when an operation frequency of a logic circuit is 500 MHz. The number of input bits to each LUT is any integer of 0 or more.

The LUT 2-0 of the second layer, which is the uppermost layer, converts a part of the transmission information bit string into a transmission shaping bit string, and outputs the transmission shaping bit string obtained by the conversion to the distribution circuit 12a of the first layer, which is the layer immediately below. The transmission shaping bit string is an information bit string for generating designation information designating a combination of signal point groups in the signal space managed by the LUT 3-0 and the LUT 3-1 of the first layer. This conversion processing is performed by table reference (table drawing). Note that the table reference is processing in which a relationship between an address and data is stored in advance, and when an address is designated, data corresponding to the address is read. An input to the LUT corresponds to an address of the LUT, and an output from the LUT corresponds to data of the LUT. The relationship between the address and the data usually has a one-to-one correspondence.

The distribution circuit 12a of the first layer converts the transmission shaping bit string into a combination of a first transmission source address bit string and a second transmission source address bit string, and outputs each bit string obtained by the conversion to the address replacing circuit 13a of the first layer. The first transmission source address bit string and the second transmission source address bit string are information bit strings serving as designation information for designating a combination of signal point groups in the signal spaces managed by the LUT 3-0 and the LUT 3-1 of the first layer.

The address replacing circuit 13a of the first layer performs processing according to the value of the transmission address replacing bit on the first transmission source address bit string and the second transmission source address bit string to obtain a first transmission address bit string and a second transmission address bit string. The address replacing circuit 13a of the first layer outputs the obtained first transmission address bit string to the LUT 3-1 of the first layer and outputs the second transmission address bit string to the LUT 3-0 of the first layer.

The LUT 3-0 of the first layer converts a bit sequence including a part of the transmission information bit string as the external input information and the second transmission address bit string from the address replacing circuit 13a of the first layer into a transmission shaping bit string, and outputs the transmission shaping bit string obtained by the conversion to the distribution circuit 12b of the 0-th layer which is the layer immediately below. The transmission shaping bit string is an information bit string for generating designation information designating the combination of the signal point groups in the signal space managed by the LUT 4-0 and the LUT 4-1 of the 0-th layer which is the layer immediately below.

The distribution circuit 12b of the 0-th layer converts the transmission shaping bit string into a combination of the first transmission source address bit string and the second transmission source address bit string, and outputs each bit string obtained by the conversion to the address replacing circuit 13b of the 0-th layer. The first transmission source address bit string and the second transmission source address bit string are information bit strings serving as designation information for designating a combination of signal point groups in the signal spaces managed by the LUT 4-0 and the LUT 4-1 of the 0-th layer.

The address replacing circuit 13b of the 0-th layer performs processing according to the value of the transmission address replacing bit on the first transmission source address bit string and the second transmission source address bit string to obtain a first transmission address bit string and a second transmission address bit string. The address replacing circuit 13b of the 0-th layer outputs the obtained first transmission address bit string to the LUT 4-1 of the 0-th layer and outputs the second transmission address bit string to the LUT 4-0 of the 0-th layer.

The LUT 3-1 of the first layer basically operates similarly to the LUT 3-0 of the first layer. Further, the distribution circuit 12c and the address replacing circuit 13c of the 0-th layer following the LUT 3-1 of the first layer basically operate similarly to the distribution circuit 12b and the address replacing circuit 13b of the 0-th layer following the LUT 3-0 of the first layer described above.

The LUT 4-0 and the LUT 4-1 of the 0-th layer which is the lowest layer convert a bit sequence including a part of the transmission information bit string as the external input information and the second transmission address bit string from the address replacing circuit 13b of the 0-th layer into signal point information indicating a signal point arrangement of the signal spaces managed by the LUT 4-0 and the LUT 4-1, and output the signal point information to the outside. The LUT 4-2 and the LUT 4-3 convert a bit sequence including a part of the transmission information bit string as the external input information and the first transmission address bit string from the 0-th layer address replacing circuit 13c into signal point information indicating a signal point arrangement of the signal spaces managed by the LUT 4-2 and the LUT 4-3, and output the signal point information to the outside.

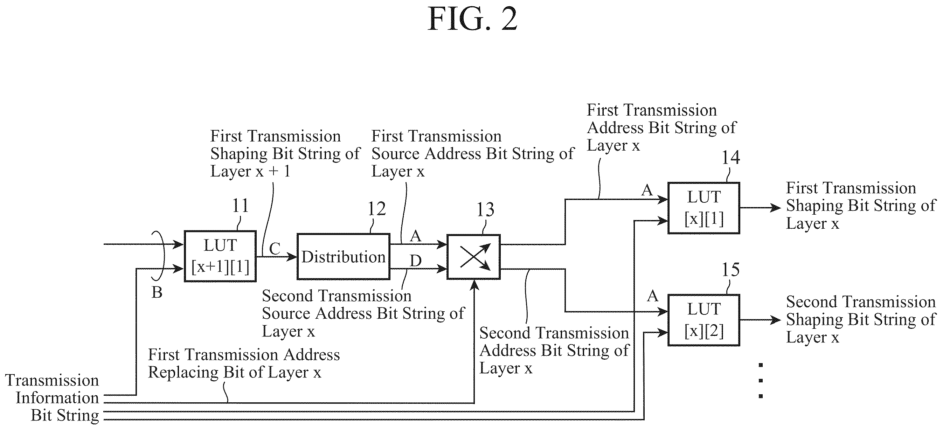

FIG. 2 is a diagram extracting and illustrating a circuit configuration between a (x + 1)-th layer and an x-th layer immediately below the (x + 1)-th layer as a representative example in the probabilistic shaping encoding circuit 1 illustrated in FIG. 1. Note that, in the following description, for convenience of description, the (x + 1)-th layer is denoted as a "layer x + 1 ", and the x-th layer is denoted as a "layer x". Further, in FIG. 2, the LUTs illustrated in FIG. 1 are generalized in a form independent of the layer, and the LUTs are denoted by reference numerals 11, 14, and 15.

Further, in FIG. 2, a first LUT 11 of the layer x + 1 is denoted as LUT [x + 1][1], a first LUT 14 of the layer x is denoted as LUT [x][1], and a second LUT 15 of the layer x is denoted as LUT [x][2]. Further, in FIG. 2, the number of bits of the input/output bit string in each of the first LUT 11, the distribution circuit 12, and the address replacing circuit 13 of the layer x + 1 is represented by symbols A to D (all are non-negative integers). At this time, among the respective numbers of bits, relationships of C > B, A ≥ D, and A + D ≥ B are established.

### <First LUT 11 of layer x + 1>

The first LUT 11 of the layer x + 1 receives a first transmission bit string (the number of bits: B) of the layer x + 1 from the outside (not illustrated) as an input, and outputs a first transmission shaping bit string (the number of bits: C) of the layer x + 1. Specifically, the first LUT 11 of the layer x + 1 converts the input first transmission bit string of the layer x + 1 into the first transmission shaping bit string of the layer x + 1 by referring to the table, and outputs the first transmission shaping bit string.

Here, the first transmission bit string of the layer x + 1 to be an input includes, for example, a first transmission address bit string of the layer x + 1 from the outside (not illustrated) and a first transmission information bit string of the layer x + 1 from the outside (not illustrated). Here, the first transmission address bit string of the layer x + 1 is 0 when the layer x + 1 is the uppermost layer.

Further, when the layer x + 1 is an intermediate layer from immediately below the uppermost layer to immediately above the lowermost layer, the first transmission address bit string of the layer x + 1 is a bit string output from the address replacing circuit 13 in the previous stage of the first LUT 11 of the layer x + 1.

### <First distribution circuit 12 of layer x>

The first distribution circuit 12 of the layer x receives the first transmission shaping bit string (the number of bits: C) of the layer x + 1 output from the first LUT 11 of the layer x + 1 as an input, and outputs the first transmission source address bit string (the number of bits: A) of the layer x and the second transmission source address bit string (the number of bits: D) of the layer x.

Specifically, the first distribution circuit 12 of the layer x converts the input first transmission shaping bit string of the layer x + 1 into a combination of the first transmission source address bit string of the layer x and the second transmission source address bit string of the layer x by referring to the table, and outputs each bit string obtained by the conversion.

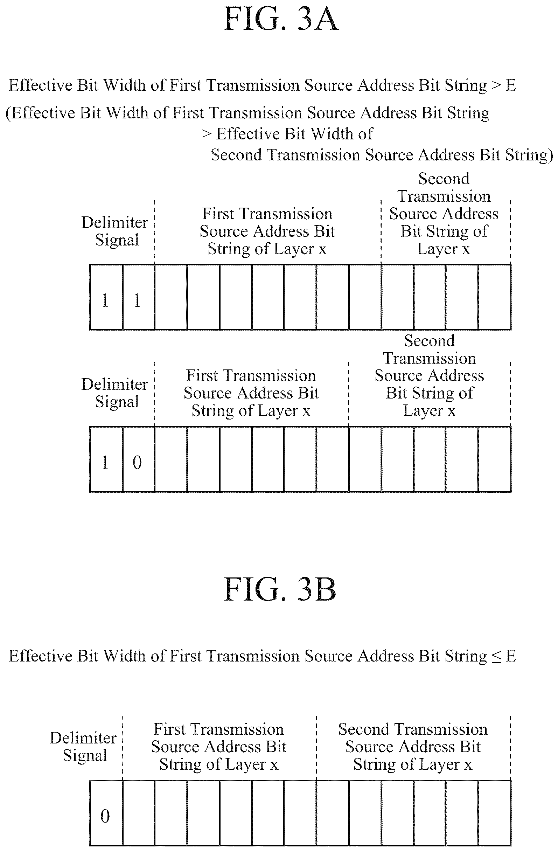

Here, an example of processing by the first distribution circuit 12 of the layer x will be described with reference to FIG. 3. For example, as illustrated in FIGS. 3A and 3B, the first distribution circuit 12 of the layer x sets the first bit or the 1 to 2 bit of the input first transmission shaping bit string of the layer x + 1 as a delimiter signal, and changes the manner of conversion according to the value of the delimiter signal.

Further, at this time, the distribution circuit 12 performs the conversion in such a manner that the magnitude relationship between the value indicated by the first transmission source address bit string of the layer x and the value indicated by the second transmission source address bit string of the layer x obtained by the conversion is one of (a) a case where the values are even values equal to each other, or (b) a case where the values are different from each other, and the value indicated by the first transmission source address bit string of the layer x is larger than the value indicated by the second transmission source address bit string of the layer x.

As an example, for example, it is assumed that the number of bits of the first transmission shaping bit string of the layer x + 1 input to the distribution circuit 12 is 13 bits (C = 13).

### <Case 0>

In this case, when the first bit of the input first transmission shaping bit string of the layer x + 1 is "0", as illustrated in FIG. 3B, the distribution circuit 12 allocates the 12 bits from the second bit to the 13th bit following "0" to six bits at a time. That is, the distribution circuit 12 sets six bits from the 2nd bit to the 7th bit of the first transmission shaping bit string of the layer x + 1 as the first transmission source address bit string of the layer x, and sets six bits from the 8th bit to the 13th bit as the second transmission source address bit string of the layer x. In this case, since the above-described six bits are the first transmission source address bit string of the layer x, the effective bit width of the first transmission source address bit string is equal to or less than 6 (= E). Hereinafter, this case is also referred to as a "case 0".

### <Case 1>

Further, when the first bit of the input first transmission shaping bit string of the layer x + 1 is "1", the distribution circuit 12 refers to the second bit following "1" as illustrated in FIG. 3A. When the second bit is "0", the distribution circuit 12 allocates 11 bits from the third bit to the 13th bit following "0" to six bits and five bits. That is, the distribution circuit 12 sets six bits from the 3rd bit to the 8th bit of the first transmission shaping bit string of the layer x + 1 as the first transmission source address bit string of the layer x, and sets five bits from the 9th bit to the 13th bit as the second transmission source address bit string of the layer x.

Further, in this case, the distribution circuit 12 newly adds "1" as the seventh bit to the left of the most significant bit (sixth bit) of the first transmission source address bit string of the layer x, and outputs the obtained first transmission source address bit string. This is synonymous with adding an offset value "64" to the address determined by the first transmission source address bit string of the layer x. Note that, in this case, since the first transmission source address bit string of the layer x is seven bits, the effective bit width of the bit string is larger than 6 (= E). Hereinafter, this case is also referred to as a "case 1".

### <Case 2>

On the other hand, if the value of the second bit following "1" of the first bit is "1", the distribution circuit 12 allocates the 11 bits from the third bit to the 13th bit following "1" to seven bits and four bits. That is, the distribution circuit 12 sets seven bits from the 3rd bit to the 9th bit of the first transmission shaping bit string of the layer x + 1 as the first transmission source address bit string of the layer x, and sets four bits from the 10th bit to the 13th bit as the second transmission source address bit string of the layer x.

Further, in this case, the distribution circuit 12 newly adds "1" as the 8th bit to the left of the most significant bit (7th bit) of the first transmission source address bit string of the layer x, and outputs the obtained first transmission source address bit string. This is synonymous with adding the offset value "128" to the address determined by the first transmission source address bit string of the layer x. Note that, in this case, since the first transmission source address bit string of the layer x is eight bits, the effective bit width of the bit string is larger than 6 (= E). Hereinafter, this case is also referred to as a "case 2".

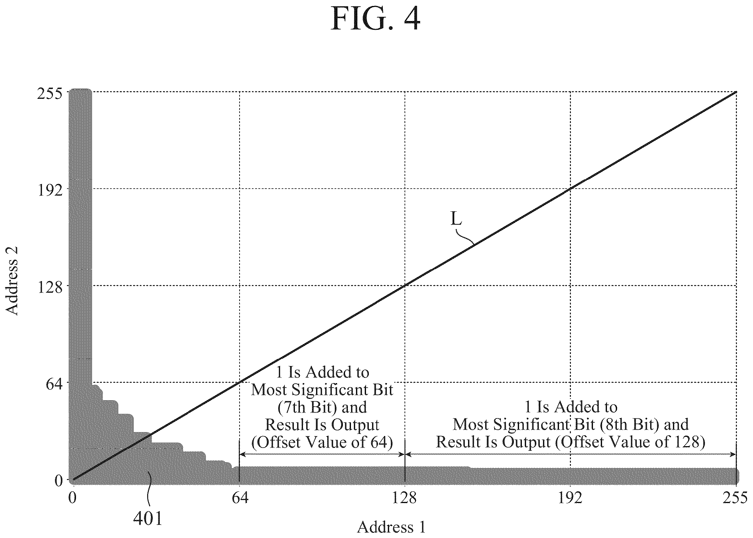

Here, the processing by the first distribution circuit 12 of the layer x will be supplemented with reference to FIG. 4. FIG. 4 is a graph in which the signal point arrangement defined by the signal point information is expressed by a combination of a first address (Address1) and a second address (Address2). In FIG. 4, the horizontal axis represents a first address, and the vertical axis represents a second address. For example, when each of the first address and the second address is expressed by eight bits, the signal point information indicating one signal point arrangement is expressed by 16 bits (= 8 + 8). Further, in this case, the number of possible addresses for one signal point arrangement is 65536 (= 2¹⁶) in total.

Further, a straight line L illustrated in FIG. 4 illustrates signal point arrangement in a case where the first address and the second address are equal. For example, among the signal point arrangements on the straight line L, a signal point arrangement in which both the first address and the second address are "2" is expressed as "0000001000000010", and a signal point arrangement in which both the first address and the second address are "8" is expressed as "0000100000001000".

Among these, the probabilistic shaping encoding circuit 1 uses, for example, 4096 signal point arrangements that are considered to include a large number of "0" in the signal point information as signal points having relatively small power. 4096 ways in this case correspond to, for example, a signal point arrangement of a gray portion indicated by reference numeral 401 in FIG. 4. Note that the signal point arrangement indicated by reference numeral 401 can be expressed by 12 bits.

At this time, as described above, the distribution circuit 12 performs the conversion in such a manner that the magnitude relationship between the value indicated by the first transmission source address bit string of the layer x and the value indicated by the second transmission source address bit string of the layer x obtained by the conversion is one of (a) a case where the values are even values equal to each other, or (b) a case where the values are different from each other, and the value indicated by the first transmission source address bit string of the layer x is larger than the value indicated by the second transmission source address bit string of the layer x.

Here, the signal point arrangement in the case where the relationship between the two values is (a) is located on a straight line L exactly in the gray portion indicated by reference numeral 401. In this case, the signal point arrangement is expressed as, for example, "0000001000000010" corresponding to a case where the first address and the second address have even values "2" equal to each other, "0000100000001000" corresponding to a case where the first address and the second address have even values "8" equal to each other, or the like.

Further, the signal point arrangement in the case where the relationship between the two values is (b) is located exactly in the gray portion indicated by reference numeral 401 and in a portion on the right side (closer to the horizontal axis) of the straight line L. In this case, the signal point arrangement is expressed as, for example, "0000001100000001" corresponding to a case where the first address is "3" and the second address is "1", "0000011100000001" corresponding to a case where the first address is "7" and the second address is "1", or the like.

That is, the distribution circuit 12 performs the conversion in such a manner as to correspond to the above (a) or (b), thereby determining the signal point arrangement in such a manner as to be located at least on the straight line L within the gray portion indicated by reference numeral 401 or on the right side (close to the horizontal axis) of the straight line L. Furthermore, the distribution circuit 12 employs the concept of the offset value described above in order to improve the efficiency in determining the signal point arrangement as described above.

For example, when the range of the first address is from "0" to "63", that is, when the effective bit width of the first address is equal to or less than 6 (case 0 described above), the distribution circuit 12 does not use the offset value. On the other hand, when the range of the first address is from "64" to "127", that is, when the effective bit width of the first address is larger than 6 and corresponds to Case 1 described above, the distribution circuit 12 newly adds "1" as the 7th bit to the left of the most significant bit (6th bit) of the first transmission source address bit string of the layer x, and outputs the obtained first transmission source address bit string. This is synonymous with adding the offset value "64" to a value that can be expressed by the first transmission source address bit string (six bits) of the layer x.

Further, when the range of the first address is from "128" to "255", that is, when the effective bit width of the first address is larger than 6 and corresponds to Case 2 described above, the distribution circuit 12 newly adds "1" as the 8th bit to the left of the most significant bit (7 bits) of the first transmission source address bit string (seven bits) of the layer x, and outputs the obtained first transmission source address bit string. This is synonymous with adding the offset value "128" to a value that can be expressed by the first transmission source address bit string (six bits) of the layer x.

As described above, the distribution circuit 12 can reduce the number of bits to be processed at the time of conversion by employing the idea of the offset value to newly add "1" after conversion. Further, this also leads to a reduction in the number of bits of the first transmission shaping bit string of the layer x + 1 input from the first LUT 11 of the layer x + 1 to the distribution circuit 12.

### <First address replacing circuit 13 of Layer x>

The first address replacing circuit 13 of the layer x receives the first transmission source address bit string (bit number: A) of the layer x and the second transmission source address bit string (bit number: D) of the layer x, which are output from the first distribution circuit 12 of the layer x, and a first transmission address replacing bit of the layer x from the outside (not illustrated) as an input, and outputs the first transmission address bit string (bit number: A at the maximum) of the layer x and the second transmission address bit string (bit number: A at the maximum) of the layer x.

Specifically, the first address replacing circuit 13 of the layer x performs processing according to the value of the first transmission address replacing bit of the layer x on the first transmission source address bit string of the layer x and the second transmission source address bit string of the layer x to obtain the first transmission address bit string of the layer x and the second transmission address bit string of the layer x. The address replacing circuit 13 outputs each obtained bit string. Note that the first transmission address replacing bits of the layer x are some bits of a transmission information bit string from the outside.

Hereinafter, a specific example of processing by the address replacing circuit 13 will be described. As described above, there are two types of magnitude relationships between the value indicated by the first transmission source address bit string of the layer x and the value indicated by the second transmission source address bit string of the layer x input to the address replacing circuit 13: (a) a case where the values are even values equal to each other; and (b) a case where the values are different from each other, and the value indicated by the first transmission source address bit string of the layer x is larger than the value indicated by the second transmission source address bit string of the layer x. Further, the first address replacing bit (hereinafter, also simply referred to as a "replacing bit") of the layer x input to the address replacing circuit 13 has two types of bits of "0" and "1".

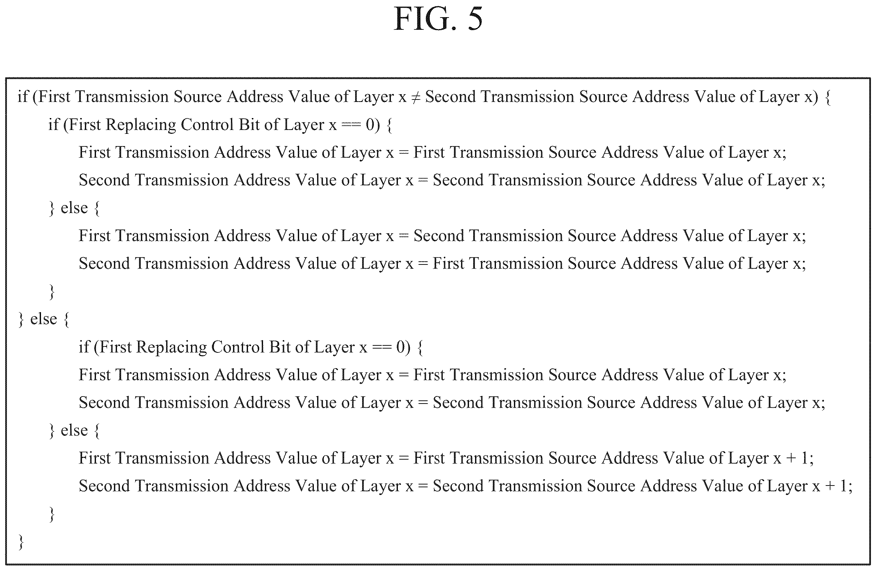

Accordingly, the address replacing circuit 13 performs processing according to the following four cases. Note that FIG. 5 illustrates an example of an algorithm describing processing in the following four cases.
(1) Case A; the magnitude relationship is (a), and the replacing bit is "0".
(2) Case B; the magnitude relationship is (a), and the replacing bit is "1".
(3) Case C; the magnitude relationship is (b), and the replacing bit is "0".
(4) Case D; the magnitude relationship is (b), and the replacing bit is "1".

### (Case A)

The address replacing circuit 13 sets the first transmission address bit string of the layer x and the second transmission address bit string of the layer x to be output to the same value as the input first transmission source address bit string of the layer x (= the second transmission source address bit string of the layer x).

### (Case B)

The address replacing circuit 13 sets the first transmission address bit string of the layer x and the second transmission address bit string of the layer x to be output as values obtained by adding "1" to the input first transmission source address bit string of the layer x (= the second transmission source address bit string of the layer x).

### (Case C)

The address replacing circuit 13 sets the first transmission address bit string of the layer x to be output as the input first transmission source address bit string of the layer x, and sets the second transmission address bit string of the layer x to be output as the input second transmission source address bit string of the layer x.

### (Case D)

The address replacing circuit 13 sets the first transmission address bit string of the layer x to be output as the input second transmission source address bit string of the layer x, and sets the second transmission address bit string of the layer x to be output as the input first transmission source address bit string of the layer x.

Here, the processing by the address replacing circuit 13 will be supplemented with reference to FIG. 4. In FIG. 4, the first address on the horizontal axis corresponds to the address defined by the first transmission source address bit string of the layer x, and the second address on the vertical axis corresponds to the address defined by the second transmission source address bit string of the layer x.

When the input replacing bit is "1", the address replacing circuit 13 basically replaces the first address and the second address. This replacement corresponds to the signal point arrangement indicated by the reference numeral 401 in FIG. 4 being moved to symmetrical positions on the opposite side (close to the vertical axis) with the straight line L as a boundary.

For example, in a case where the signal point arrangement is expressed as "0000011100000001" corresponding to a case where the first address is "7" and the second address is "1", when the input replacing bit is "1", the address replacing circuit 13 replaces both the addresses as illustrated in the case D, and sets the first address to "1" and the second address to "7". In this case, the signal point arrangement is expressed as "0000000100000111" in which the first eight bits and the second eight bits of the original bit string are interchanged.

However, in a case where the signal point arrangement is located exactly on the straight line L, for example, in a case where the signal point arrangement is expressed as "0000001000000010" corresponding to a case where the first address and the second address have even values "2" equal to each other, the original signal point arrangement can be obtained in the end even if the address replacing circuit 13 performs the replacement as described above. Accordingly, in this case, the address replacing circuit 13 sets odd-numbered addresses obtained by adding "1" to the first address (= the second address) as a new first address (that is, the first transmission address bit string) and a new second address (that is, the second transmission address bit string) as illustrated in the above-described case B. In this case, the address replacing circuit 13 obtains the signal point arrangement expressed as "0000001100000011" in which the first address is "3" and the second address is "3" as the new signal point arrangement.

On the other hand, when the replacing bit is "0", the address replacing circuit 13 does not replace the first address and the second address as described in the above Cases A and C. Thus, the probabilistic shaping encoding circuit 1 can uniformly and efficiently express the 4096 signal point arrangements indicated by reference numeral 401 in FIG. 4.

Note that, in the above description, an example has been described in which the distribution circuit 12 performs conversion in such a manner that the magnitude relationship between the value indicated by the first transmission source address bit string of the layer x and the value indicated by the second transmission source address bit string of the layer x is one of (a) a case where the values are even values equal to each other, or (b) a case where the values are different from each other, and the value indicated by the first transmission source address bit string of the layer x is larger than the value indicated by the second transmission source address bit string of the layer x. However, this is an example, and the example of conversion is not limited to the above example. For example, the distribution circuit 12 may perform conversion in such a manner that the above magnitude relationship is one of (c) a case where the values are odd values equal to each other or (d) a case where the values are different from each other, and the value indicated by the first transmission source address bit string of the layer x is smaller than the value indicated by the second transmission source address bit string of the layer x. Further, in the case of (c), if the replacing bit is "1", the address replacing circuit 13 may add "1" to the above two values to make them even.

### <First LUT 14 of layer x>

The first LUT 14 of the layer x receives the first transmission bit string of the layer x as an input, and outputs the first transmission shaping bit string of the layer x to the outside (not illustrated). Specifically, the first LUT 14 of the layer x converts the input first transmission bit string of the layer x into the first transmission shaping bit string of the layer x by referring to the table, and outputs the first transmission shaping bit string.

Here, the first transmission bit string of the layer x to be an input includes two bit strings, that is, the first transmission address bit string (the number of bits: A at the maximum) of the layer x output from the address replacing circuit 13 and the first transmission information bit string of the layer x from the outside (not illustrated).

Note that, in a case where the layer x is the lowest layer, the first transmission shaping bit string of the layer x to be an output corresponds to the signal point information indicating the signal point arrangement of the signal space managed by the first LUT 14 of the layer x on a one-to-one basis. Further, in a case where the layer x is an intermediate layer from immediately below the uppermost layer to immediately above the lowermost layer, the first transmission shaping bit string of the layer x corresponds to the designation information designating the combination of the signal point groups in the signal space managed by the first LUT 11 in the layer (layer) immediately below the layer x on a one-to-one basis.

### <Second LUT 15 of layer x>

The second LUT 15 of the layer x receives the second transmission bit string of the layer x as an input, and outputs the second transmission shaping bit string of the layer x to the outside (not illustrated). Specifically, the second LUT 15 of the layer x converts the input second transmission bit string of the layer x into the second transmission shaping bit string of the layer x by referring to the table, and outputs the second transmission shaping bit string.

Here, the second transmission bit string of the layer x to be an input includes two bit strings, that is, the second transmission address bit string (the number of bits: A at the maximum) of the layer x output from the address replacing circuit 13 and the second transmission information bit string of the layer x from the outside (not illustrated).

Note that, in a case where the layer x is the lowest layer, the second transmission shaping bit string of the layer x to be an output corresponds to the signal point information indicating the signal point arrangement of the signal space managed by the second LUT 15 of the layer x on a one-to-one basis. Further, when the layer x is the intermediate layer, the second transmission shaping bit string of the layer x corresponds to the designation information designating the combination of the signal point groups in the signal space managed by the second LUT 15 in the layer (layer) immediately below the layer x on a one-to-one basis.

Note that, in the above description, an example has been described in which the first transmission information bit string of the layer x + 1 is input to the first LUT 11 of the layer x + 1, the first transmission information bit string of the layer x is input to the first LUT 14 of the layer x, and the second transmission information bit string of the layer x is input to the second LUT 15 of the layer x. However, the number of bits of each transmission information bit string input to each LUT may be 0. In this case, the probabilistic shaping encoding circuit 1 can further suppress performance deterioration.

In particular, in a circuit including an LUT group having a hierarchical configuration such as the probabilistic shaping encoding circuit 1, the number of bits of a transmission information bit string input from the outside for each LUT may affect the performance. This is because the transmission information bit string input from the outside has a random value. In this regard, the probabilistic shaping encoding circuit 1 does not handle bit strings having random values in the LUT by setting the number of bits of the transmission information bit string input to any LUT among the LUTs to 0. Further, in this case, the LUT only needs to generate the transmission shaping bit string from the transmission address bit string to be an input from the upper layer, but the value of the transmission address bit string to be an input from the upper layer is not random and can be set in advance. Therefore, the probabilistic shaping encoding circuit 1 can further suppress performance deterioration.

Further, in particular, in the probabilistic shaping encoding circuit 1, the number of bits of an input bit string may be smaller than the number of bits of an output bit string, but in this case, the number of bits of the input transmission information bit string to be input may be set to 0 in order from the LUT located in the lower layer. For example, when the layer x is the lowest layer, the number of bits of at least one of the first transmission information bit string of the layer x input to the first LUT 14 of the layer x or the second transmission information bit string of the layer x input to the second LUT 15 of the layer x may be set to 0. Thus, the probabilistic shaping encoding circuit 1 can further suppress performance deterioration.

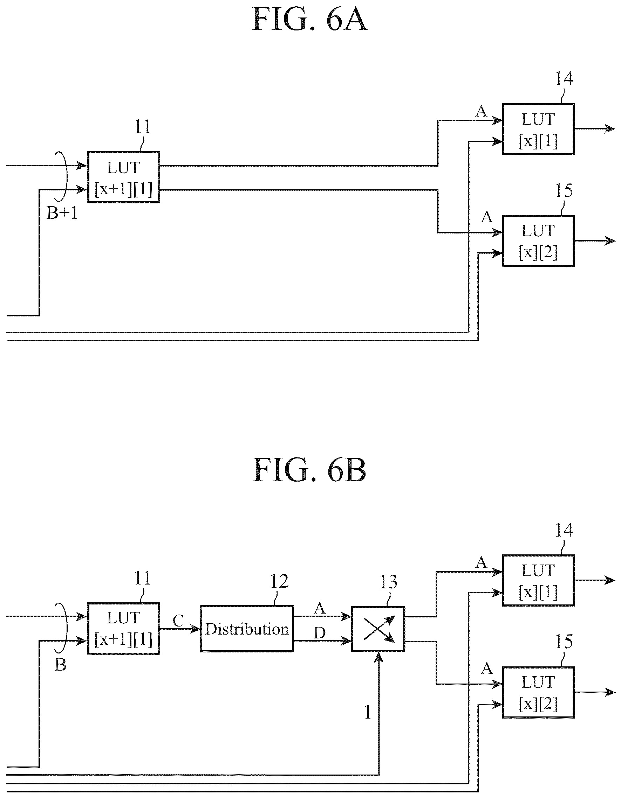

Next, an effect of the probabilistic shaping encoding circuit 1 according to the first embodiment will be described with reference to FIG. 6.

FIG. 6A illustrates a configuration example (hereinafter, also referred to as "conventional example") of a conventional probabilistic shaping encoding circuit, and FIG. 6B illustrates a configuration example (hereinafter, also referred to as "present configuration example") of the probabilistic shaping encoding circuit 1 according to the first embodiment. The conventional example and the present configuration example differ only in whether or not the distribution circuit 12 and the address replacing circuit 13 are provided.

In FIGS. 6A and 6B, the number of bits of a bit string input to and output from each component is indicated by A to D (all non-negative integers). For example, in the conventional example illustrated in FIG. 6A, the number of bits of the bit string input to the m-th LUT 11 of the layer x + 1 is B + 1, and the numbers of bits of the bit string input to the (2m-1)-th LUT 14 of the layer x and the bit string input to the 2m-th LUT 15 of the layer x are A.

Further, in the present configuration example illustrated in FIG. 6B, the number of bits of the m-th transmission bit string of the layer x + 1 input to the m-th LUT 11 of the layer x + 1 is B, the number of bits of the m-th transmission shaping bit string of the layer x + 1 input to the m-th distribution circuit 12 of the layer x is C, the number of bits of the (2m-1)-th transmission source address bit string of the layer x input to the m-th address replacing circuit 13 of the layer x is A, the number of bits of the 2m-th transmission source address bit string of the layer x is D, and the number of bits of the m-th transmission address replacing bit of the layer x is 1.

Further, in the present configuration example illustrated in FIG. 6B, the number of bits of the (2m-1)-th transmission address bit string of the layer x input to the (2m-1)-th LUT 14 of the layer x and the 2m-th transmission address bit string of the layer x input to the 2m-th LUT 15 of the layer x is A at the maximum (equal to or less than A).

Here, for example, assuming that A is eight bits, B is 10 bits, C is 12 bits, and D is six bits, in the conventional example illustrated in FIG. 6A, the number of bits of the input/output bit string with respect to the first LUT 11 of the layer x + 1 is 11 bits (= B + 1) for input and 16 bits (= A × 2) for output. Note that "+1" of the number of bits on the input side is obtained by regarding one bit of the replacing bits input to the address replacing circuit 13 as an input to the first LUT 11 of the layer x + 1 in the present configuration example illustrated in FIG. 6B. At this time, the scale of the first LUT 11 of the layer x + 1 in the conventional example is 2A × 2^{B+1} = 16 × 2¹¹ = 32768.

On the other hand, in the present configuration example illustrated in FIG. 6B, the number of bits of the input/output bit string with respect to the first LUT 11 of the layer x + 1 is 10 bits (= B) for input and 12 bits (= C) for output. At this time, the scale of the first LUT 11 of the layer x + 1 in the present configuration example is C × 2^{B} = 12 × 2¹⁰ = 12228.

Therefore, in the present configuration example, the scale of the first LUT 11 of the layer x + 1 can be reduced by 60% or more as compared with the conventional example. Further, in general, the sizes of the distribution circuit 12 and the address replacing circuit 13 are sufficiently small for an LUT of this size (for example, an LUT of 10 kilobit order) and are negligible.

In the conventional example, it is necessary to increase the number of input/output bits with respect to each LUT (for example, the first LUT 11 of the layer x + 1) in order to suppress the performance deterioration, but if the number of input/output bits is increased, the circuit scale increases. On the other hand, in the present configuration example, the distribution circuit 12 and the address replacing circuit 13 are provided at the subsequent stage of the first LUT 11 of the layer x + 1, and the above-described processing is performed by these circuits, so that it is possible to reduce the circuit scale while suppressing the performance deterioration as compared with the conventional example. In particular, in the present configuration example, the effect becomes remarkable by setting the relationship of the numbers of bits of the input/output bit string with respect to each component to C > B, A ≥ D, and A + D ≥ B.

Note that, in the present configuration example, even if the address replacing circuit 13 is omitted, a certain effect can be obtained. For example, when the address replacing circuit 13 is omitted in the present configuration example, the first transmission source address bit string of the layer x output from the distribution circuit 12 is directly input to the first LUT 14 of the layer x, and the second transmission source address bit string of the layer x output from the distribution circuit 12 is directly input to the second LUT 15 of the layer x.

Further, in this case, the first LUT 14 of the layer x generates the first transmission shaping bit string of the layer x from the first transmission source address bit string of the layer x output from the distribution circuit 12 and the first transmission information bit string of the layer x from the outside (not illustrated). Furthermore, the second LUT 15 of the layer x generates the second transmission shaping bit string of the layer x from the second transmission source address bit string of the layer x output from the distribution circuit 12 and the second transmission information bit string of the layer x from the outside (not illustrated).

Further, in this case, for example, one bit of the replacing bit input to the address replacing circuit 13 is input to the first LUT 11 of the layer x + 1. In this case, the scale of the first LUT 11 of the layer x + 1 is C × 2^{B+1} = 12 × 2¹¹ = 24576. Therefore, in the present configuration example, even if the address replacing circuit 13 is omitted, the scale of the first LUT 11 of the layer x + 1 can be reduced by 25% as compared with the conventional example.

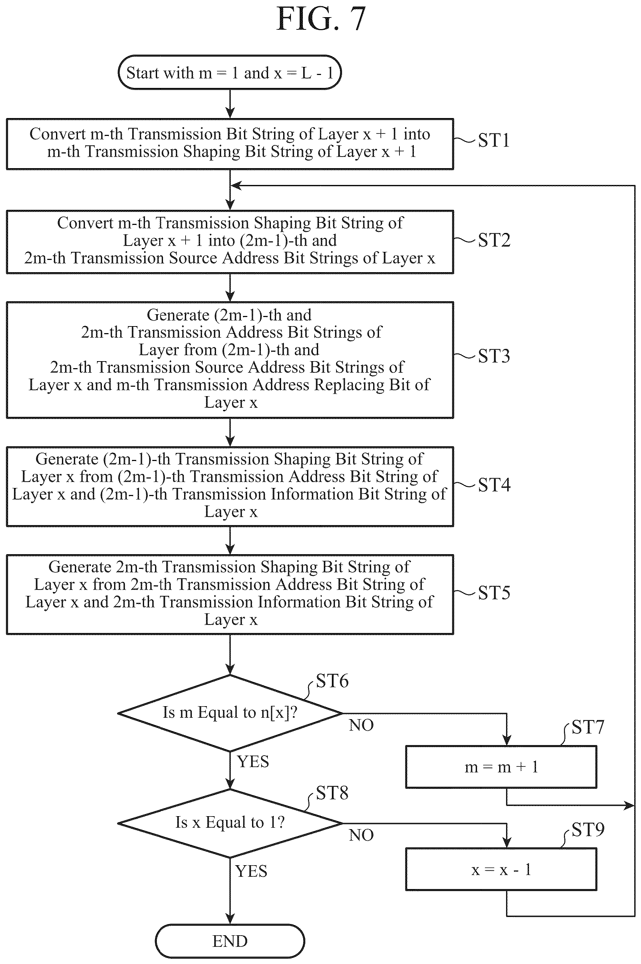

Next, an operation example of the probabilistic shaping encoding circuit 1 according to the first embodiment will be described with reference to FIG. 7. This flowchart starts with m = 1 and x = L-1. Here, L is the number of layers of the LUT group hierarchized in a tree shape.

First, the m-th LUT 11 of the layer x + 1 converts the m-th transmission bit string of the layer x + 1 into the m-th transmission shaping bit string of the layer x + 1 by referring to the table (step ST1).

Next, the m-th distribution circuit 12 of the layer x converts the m-th transmission shaping bit string of the layer x + 1 into the (2m-1)-th transmission source address bit string of the layer x and the 2m-th transmission source address bit string of the layer x (step ST2).

Next, the m-th address replacing circuit 13 of the layer x generates the (2m-1)-th transmission address bit string of the layer x and the 2m-th transmission address bit string of the layer x from the (2m-1)-th transmission source address bit string of the layer x and the 2m-th transmission source address bit string of the layer x, and the m-th transmission address replacing bit of the layer x (step ST3).

Next, the (2m-1)-th LUT 14 of the layer x generates a (2m-1)-th transmission shaping bit string of the layer x from the (2m-1)-th transmission address bit string of the layer x and the (2m-1)-th transmission information bit string of the layer x (step ST4).

Next, the 2m-th LUT 15 of the layer x generates a 2m-th transmission shaping bit string of the layer x from the 2m-th transmission address bit string of the layer x and the 2m-th transmission information bit string of the layer x (step ST5).

Next, the probabilistic shaping encoding circuit 1 determines whether or not m is equal to n[x] (step ST6). Here, n[x] is a natural number indicating how many units are present in one layer when the distribution circuit 12, the address replacing circuit 13, the LUT 14, and the LUT 15 are regarded as one unit.

As a result, when it is determined that m is not equal to n[x] (step ST6; NO), m is counted up by one (step ST7), and the processing returns to step ST2. On the other hand, when it is determined that m is equal to n[x] (step ST6; YES), the processing proceeds to step ST8, and the probabilistic shaping encoding circuit 1 determines whether or not x is equal to 1 (step ST8).

As a result, when it is determined that x is not equal to 1 (step ST8; NO), x is counted down by one (step ST9), and the processing returns to step ST2. On the other hand, when it is determined that x is equal to 1 (step ST8; YES), the processing ends.

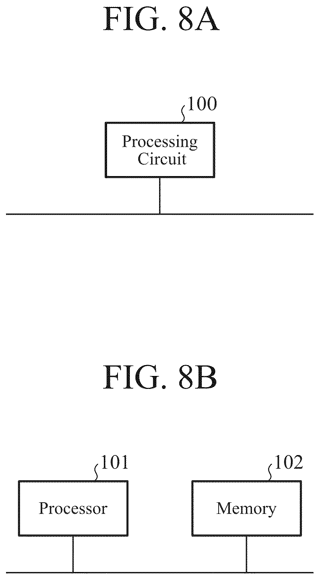

FIG. 8A is a block diagram illustrating hardware components that implement the functions of the probabilistic shaping encoding circuit 1. FIG. 8B is a block diagram illustrating a hardware configuration that executes software that implements the functions of the probabilistic shaping encoding circuit 1.

In a case where the processing circuit is a processing circuit 100 of dedicated hardware illustrated in FIG. 8A, the processing circuit 100 corresponds to, for example, a single circuit, a composite circuit, a programmed processor, a parallel programmed processor, an application specific integrated circuit (ASIC), a field-programmable gate array (FPGA), or a combination thereof. The functions of the LUT in the probabilistic shaping encoding circuit 1 may be implemented by separate processing circuits, or these functions may be collectively implemented by one processing circuit.

In a case where the processing circuit is a processor 101 illustrated in FIG. 8B, the functions of the LUT included in the probabilistic shaping encoding circuit 1 are implemented by software, firmware, or a combination of software and firmware. Note that the software or firmware is described as a program and stored in the memory 102. The processor 101 implements the functions of the LUT in the probabilistic shaping encoding circuit 1 by reading and executing programs stored in the memory 102. For example, the information processing device 1 includes the memory 102 for storing a program that, when executed by the processor 101, results in execution of the processing of steps ST1 to ST9 illustrated in FIG. 7.

These programs cause a computer to execute a procedure or a method of the LUT in the probabilistic shaping encoding circuit 1. The memory 102 may be a computer-readable storage medium storing a program for causing a computer to function as the LUT in the probabilistic shaping encoding circuit 1.

The memory 102 corresponds to a nonvolatile or volatile semiconductor memory such as a random access memory (RAM), a read only memory (ROM), a flash memory, an erasable programmable read only memory (EPROM), or an electrically-EPROM (EEPROM), a magnetic disk, a flexible disk, an optical disk, a compact disk, a mini disk, or a DVD.

As described above, according to the first embodiment, the probabilistic shaping encoding circuit 1 includes: with x, m, and n[x] being natural numbers (m = 1, 2,..., n[x]), the m-th lookup table 11 of a layer x + 1 to convert an m-th transmission bit string of the layer x + 1 including an m-th transmission information bit string of the layer x + 1 which is a part of an information bit sequence of a communication target and an m-th transmission address bit string of the layer x + 1 into an m-th transmission shaping bit string of the layer x + 1; the m-th distribution circuit 12 of the layer x to convert the m-th transmission shaping bit string of the layer x + 1 into a (2m-1)-th transmission source address bit string of the layer x and a 2m-th transmission source address bit string of the layer x; the (2m-1)-th lookup table 14 of the layer x to generate a (2m-1)-th transmission shaping bit string of the layer x from the (2m-1)-th transmission source address bit string of the layer x and a (2m-1)-th transmission information bit string of the layer x which is a part of the information bit sequence of the communication target; and the 2m-th lookup table 15 of the layer x to generate a 2m-th transmission shaping bit string of the layer x from the 2m-th transmission source address bit string of the layer x and a 2m-th transmission information bit string of the layer x which is a part of the information bit sequence of the communication target.

Each of the lookup tables is hierarchized in a tree shape, each of the transmission source address bit strings obtained by the m-th distribution circuit 12 of the layer x corresponds to designation information designating a combination of signal point groups in a signal space managed by each of a plurality of lookup tables of the layer x, and each of the transmission shaping bit strings generated by the (2m-1)-th lookup table 14 of the layer x and the 2m-th lookup table 15 of the layer x corresponds to designation information designating a combination of signal point groups in a signal space managed by each of a plurality of lookup tables of a layer immediately below or signal point information indicating a signal point arrangement of the signal space.

Thus, the probabilistic shaping encoding circuit 1 according to the first embodiment can reduce the circuit scale while suppressing the performance deterioration as compared with the conventional circuit.

Further, in the probabilistic shaping encoding circuit 1, A, B, C, and D are non-negative integers, and when the number of bits of the m-th transmission bit string of the layer x + 1 input to the m-th lookup table 11 of the layer x + 1 is B, the number of bits of the m-th transmission shaping bit string of the layer x + 1 output from the m-th lookup table 11 of the layer x + 1 and input to the m-th distribution circuit 12 of the layer x is C, the number of bits of the (2m-1)-th transmission source address bit string of the layer x output from the m-th distribution circuit 12 of the layer x and input to the (2m-1)-th lookup table 14 of the layer x is A, and the number of bits of the 2m-th transmission source address bit string of the layer x output from the m-th distribution circuit 12 of the layer x and input to the 2m-th lookup table 15 of the layer x is D, C > B, A ≥ D, and A + D ≥ B. Thus, the probabilistic shaping encoding circuit 1 according to the first embodiment can make the effects of suppressing the performance deterioration and reducing the circuit scale with respect to the conventional circuit remarkable.

Further, in the probabilistic shaping encoding circuit 1, the number of bits of a transmission information bit string input to any lookup table among the lookup tables is 0. Thus, the probabilistic shaping encoding circuit 1 according to the first embodiment can further suppress performance deterioration with respect to the conventional circuit.

Further, in the probabilistic shaping encoding circuit 1, when the layer x is the lowest layer, the number of bits of at least one of the (2m-1)-th transmission information bit string of the layer x input to the (2m-1)-th lookup table 14 of the layer x or the 2m-th transmission information bit string of the layer x input to the 2m-th lookup table 15 of the layer x is 0. Thus, the probabilistic shaping encoding circuit 1 according to the first embodiment can further suppress performance deterioration with respect to the conventional circuit.

Further, in the probabilistic shaping encoding circuit 1, when the layer x + 1 is the highest layer, the number of bits of the m-th transmission address bit string of the layer x + 1 constituting the transmission bit string input to the m-th lookup table of the layer x + 1 is 0. Thus, the probabilistic shaping encoding circuit 1 according to the first embodiment can suppress an increase in circuit scale with respect to the conventional circuit.

Further, in the probabilistic shaping encoding circuit 1, when the layer x is the lowest layer, the (2m-1)-th transmission shaping bit string of the layer x generated by the (2m-1)-th lookup table 14 of the layer x and the 2m-th transmission shaping bit string of the layer x generated by the 2m-th lookup table 15 of the layer x correspond to the signal point information indicating a signal point arrangement of the signal space managed by each of the lookup tables. Thus, the probabilistic shaping encoding circuit 1 according to the first embodiment can output the signal point information indicating a signal point arrangement of the signal space managed by each lookup table of the lowest layer.

Further, the probabilistic shaping encoding circuit, further including: an m-th address replacing circuit 13 of the layer x to convert the (2m-1)-th transmission source address bit string of the layer x and the 2m-th transmission source address bit string of the layer x output from the m-th distribution circuit 12 of the layer x according to a value of an m-th transmission address replacing bit of the layer x which is a part of the information bit sequence of the communication target, and generate a (2m-1)-th transmission address bit string of the layer x and a 2m-th transmission address bit string of the layer x, in which the (2m-1)-th lookup table 14 of the layer x generates the (2m-1)-th transmission shaping bit string of the layer x from the (2m-1)-th transmission address bit string of the layer x generated by the m-th address replacing circuit 13 of the layer x instead of the (2m-1)-th transmission source address bit string of the layer x and the (2m-1)-th transmission information bit string of the layer x which is a part of the information bit sequence of the communication target; and the 2m-th lookup table 15 of the layer x generates the 2m-th transmission shaping bit string of the layer x from the 2m-th transmission address bit string of the layer x generated by the m-th address replacing circuit 13 of the layer x instead of the 2m-th transmission source address bit string of the layer x and the 2m-th transmission information bit string of the layer x which is a part of the information bit sequence of the communication target. Thus, the probabilistic shaping encoding circuit 1 according to the first embodiment can uniformly and efficiently express a predetermined signal point arrangement.

Further, the m-th address replacing circuit 13 of the layer x, when a value indicated by the (2m-1)-th transmission source address bit string of the layer x and a value indicated by the 2m-th transmission source address bit string of the layer x are different from each other, and a value of the m-th transmission address replacing bit of the layer x is 0, sets the (2m-1)-th transmission source address bit string of the layer x to the (2m-1)-th transmission address bit string of the layer x, and sets the 2m-th transmission source address bit string of the layer x to the 2m-th transmission address bit string of the layer x, when the value indicated by the (2m-1)-th transmission source address bit string of the layer x is different from the value indicated by the 2m-th transmission source address bit string of the layer x, and the value of the m-th transmission address replacing bit of the layer x is 1, sets the 2m-th transmission source address bit string of the layer x to the (2m-1)-th transmission address bit string of the layer x, and sets the (2m-1)-th transmission source address bit string of the layer x to the 2m-th transmission address bit string of the layer x, when the value indicated by the (2m-1)-th transmission source address bit string of the layer x and the value indicated by the 2m-th transmission source address bit string of the layer x are equal, and the value of the m-th transmission address replacing bit of the layer x is 0, sets the (2m-1)-th transmission source address bit string of the layer x to the (2m-1)-th transmission address bit string of the layer x, and sets the 2m-th transmission source address bit string of the layer x to the 2m-th transmission address bit string of the layer x, when the value indicated by the (2m-1)-th transmission source address bit string of the layer x and the value indicated by the 2m-th transmission source address bit string of the layer x are equal, and the value of the m-th transmission address replacing bit of the layer x is 1, sets a bit string indicating a value obtained by adding 1 to the value indicated by the (2m-1)-th transmission source address bit string of the layer x is set to a (2m-1)-th transmission address bit string of the layer x, and a bit string indicating a value obtained by adding 1 to the value indicated by the 2m-th transmission source address bit string of the layer x is set to a 2m-th transmission address bit string of the layer x. Thus, the probabilistic shaping encoding circuit 1 according to the first embodiment can uniformly and efficiently express a predetermined signal point arrangement.

Note that, in the present disclosure, any component of the embodiment can be modified, or any component of the embodiment can be omitted.

### INDUSTRIAL APPLICABILITY

The present disclosure can reduce a circuit scale while suppressing performance degradation as compared with a conventional circuit, and is suitable for use in a probabilistic shaping encoding circuit and a probabilistic shaping encoding method.

### REFERENCE SIGNS LIST

1: probabilistic shaping encoding circuit, 2-0, 3-0, 3-1, 4-0, 4-1, 4-2, 4-3, 11, 14, 15: lookup table (LUT), 12, 12a, 12b, 12c: distribution circuit, 13, 13a, 13b, 13c: address replacing circuit, 100: processing circuit, 101: processor, 102: memory, 401: signal point arrangement, L: straight line

## Claims

1. A probabilistic shaping encoding circuit comprising:
with x, m, and n[x] being natural numbers (m = 1, 2,..., n[x]),
an m-th lookup table of a layer x + 1 to convert an m-th transmission bit string of the layer x + 1 including an m-th transmission information bit string of the layer x + 1 which is a part of an information bit sequence of a communication target and an m-th transmission address bit string of the layer x + 1 into an m-th transmission shaping bit string of the layer x + 1;
an m-th distribution circuit of the layer x to convert the m-th transmission shaping bit string of the layer x + 1 into a (2m-1)-th transmission source address bit string of the layer x and a 2m-th transmission source address bit string of the layer x;
a (2m-1)-th lookup table of the layer x to generate a (2m-1)-th transmission shaping bit string of the layer x from the (2m-1)-th transmission source address bit string of the layer x and a (2m-1)-th transmission information bit string of the layer x which is a part of the information bit sequence of the communication target; and
a 2m-th lookup table of the layer x to generate a 2m-th transmission shaping bit string of the layer x from the 2m-th transmission source address bit string of the layer x and a 2m-th transmission information bit string of the layer x which is a part of the information bit sequence of the communication target, wherein
each of the lookup tables is hierarchized in a tree shape,
each of the transmission source address bit strings obtained by the m-th distribution circuit of the layer x corresponds to designation information designating a combination of signal point groups in a signal space managed by each of a plurality of lookup tables of the layer x, and
each of the transmission shaping bit strings generated by the (2m-1)-th lookup table of the layer x and the 2m-th lookup table of the layer x corresponds to designation information designating a combination of signal point groups in a signal space managed by each of a plurality of lookup tables of a layer immediately below or signal point information indicating a signal point arrangement of the signal space.

2. The probabilistic shaping encoding circuit according to claim 1, wherein
A, B, C, and D are non-negative integers, and
when a number of bits of the m-th transmission bit string of the layer x + 1 input to the m-th lookup table of the layer x + 1 is B,
a number of bits of the m-th transmission shaping bit string of the layer x + 1 output from the m-th lookup table of the layer x + 1 and input to the m-th distribution circuit of the layer x is C,
a number of bits of the (2m-1)-th transmission source address bit string of the layer x output from the m-th distribution circuit of the layer x and input to the (2m-1)-th lookup table of the layer x is A, and
a number of bits of the 2m-th transmission source address bit string of the layer x output from the m-th distribution circuit of the layer x and input to the 2m-th lookup table of the layer x is D,
C > B, A ≥ D, and A + D ≥ B
are satisfied.

3. The probabilistic shaping encoding circuit according to claim 1 or 2, wherein
a number of bits of a transmission information bit string input to any lookup table among the lookup tables is 0.

4. The probabilistic shaping encoding circuit according to claim 1 or 2, wherein
when the layer x is a lowest layer,
a number of bits of at least one of the (2m-1)-th transmission information bit string of the layer x input to the (2m-1)-th lookup table of the layer x or the 2m-th transmission information bit string of the layer x input to the 2m-th lookup table of the layer x is 0.

5. The probabilistic shaping encoding circuit according to any one of claims 1 to 4, wherein
when the layer x + 1 is a highest layer,
a number of bits of the m-th transmission address bit string of the layer x + 1 constituting the transmission bit string input to the m-th lookup table of the layer x + 1 is 0.

6. The probabilistic shaping encoding circuit according to any one of claims 1 to 5, wherein
when the layer x is the lowest layer,
the (2m-1)-th transmission shaping bit string of the layer x generated by the (2m-1)-th lookup table of the layer x and the 2m-th transmission shaping bit string of the layer x generated by the 2m-th lookup table of the layer x correspond to the signal point information indicating a signal point arrangement of the signal space managed by each of the lookup tables.

7. The probabilistic shaping encoding circuit according to claim 1, further comprising:
an m-th address replacing circuit of the layer x to convert the (2m-1)-th transmission source address bit string of the layer x and the 2m-th transmission source address bit string of the layer x output from the m-th distribution circuit of the layer x according to a value of an m-th transmission address replacing bit of the layer x which is a part of the information bit sequence of the communication target, and generate a (2m-1)-th transmission address bit string of the layer x and a 2m-th transmission address bit string of the layer x, wherein
the (2m-1)-th lookup table of the layer x
generates the (2m-1)-th transmission shaping bit string of the layer x from the (2m-1)-th transmission address bit string of the layer x generated by the m-th address replacing circuit of the layer x instead of the (2m-1)-th transmission source address bit string of the layer x and the (2m-1)-th transmission information bit string of the layer x which is a part of the information bit sequence of the communication target; and
the 2m-th lookup table of the layer x
generates the 2m-th transmission shaping bit string of the layer x from the 2m-th transmission address bit string of the layer x generated by the m-th address replacing circuit of the layer x instead of the 2m-th transmission source address bit string of the layer x and the 2m-th transmission information bit string of the layer x which is a part of the information bit sequence of the communication target.

8. The probabilistic shaping encoding circuit according to claim 7, wherein
the m-th address replacing circuit of the layer x,
when a value indicated by the (2m-1)-th transmission source address bit string of the layer x and a value indicated by the 2m-th transmission source address bit string of the layer x are different from each other, and a value of the m-th transmission address replacing bit of the layer x is 0,
sets the (2m-1)-th transmission source address bit string of the layer x to the (2m-1)-th transmission address bit string of the layer x, and sets the 2m-th transmission source address bit string of the layer x to the 2m-th transmission address bit string of the layer x,
when the value indicated by the (2m-1)-th transmission source address bit string of the layer x is different from the value indicated by the 2m-th transmission source address bit string of the layer x, and the value of the m-th transmission address replacing bit of the layer x is 1,
sets the 2m-th transmission source address bit string of the layer x to the (2m-1)-th transmission address bit string of the layer x, and sets the (2m-1)-th transmission source address bit string of the layer x to the 2m-th transmission address bit string of the layer x,
when the value indicated by the (2m-1)-th transmission source address bit string of the layer x and the value indicated by the 2m-th transmission source address bit string of the layer x are equal, and the value of the m-th transmission address replacing bit of the layer x is 0,
sets the (2m-1)-th transmission source address bit string of the layer x to the (2m-1)-th transmission address bit string of the layer x, and sets the 2m-th transmission source address bit string of the layer x to the 2m-th transmission address bit string of the layer x, and
when the value indicated by the (2m-1)-th transmission source address bit string of the layer x and the value indicated by the 2m-th transmission source address bit string of the layer x are equal, and the value of the m-th transmission address replacing bit of the layer x is 1,
sets a bit string indicating a value obtained by adding 1 to the value indicated by the (2m-1)-th transmission source address bit string of the layer x is set to a (2m-1)-th transmission address bit string of the layer x, and a bit string indicating a value obtained by adding 1 to the value indicated by the 2m-th transmission source address bit string of the layer x is set to a 2m-th transmission address bit string of the layer x.

9. A probabilistic shaping encoding method performed by a probabilistic shaping encoding circuit including a plurality of lookup tables hierarchized in a tree shape, the method comprising:
with x, m, and n[x] being natural numbers (m = 1, 2,..., n[x]),
by an m-th lookup table of a layer x + 1, converting an m-th transmission bit string of the layer x + 1 including an m-th transmission information bit string of the layer x + 1 which is a part of an information bit sequence of a communication target and an m-th transmission address bit string of the layer x + 1 into an m-th transmission shaping bit string of the layer x + 1;
by an m-th distribution circuit of the layer x, converting the m-th transmission shaping bit string of the layer x + 1 into a (2m-1)-th transmission source address bit string of the layer x and a 2m-th transmission source address bit string of the layer x;
by a (2m-1)-th lookup table of the layer x, generating a (2m-1)-th transmission shaping bit string of the layer x from the (2m-1)-th transmission source address bit string of the layer x and a (2m-1)-th transmission information bit string of the layer x which is a part of the information bit sequence of the communication target; and
by a 2m-th lookup table of the layer x, generating a 2m-th transmission shaping bit string of the layer x from the 2m-th transmission source address bit string of the layer x and a 2m-th transmission information bit string of the layer x which is a part of the information bit sequence of the communication target, wherein
each of the transmission source address bit strings obtained by the m-th distribution circuit of the layer x corresponds to designation information designating a combination of signal point groups in a signal space managed by each of a plurality of lookup tables of the layer x, and
each of the transmission shaping bit strings generated by the (2m-1)-th lookup table of the layer x and the 2m-th lookup table of the layer x corresponds to designation information designating a combination of signal point groups in a signal space managed by each of a plurality of lookup tables of a layer immediately below or signal point information indicating a signal point arrangement of the signal space.
